# EUROPEAN PATENT SPECIFICATION

(11) **EP 3 745 828 B1**
(45) Date of publication and mention of the grant of the patent: **09.11.2022**
(21) Application number: 19305674.4
(22) Date of filing: 28.05.2019
(51) Int. Cl.: H05K 1/02, H05K 3/46, H05K 1/18, H05K 3/00

(54) **METHOD OF FORMING HIGH DENSITY VIAS IN A MULTILAYER SUBSTRATE**
VERFAHREN ZUR FORMUNG VON HOCHDICHTEN DURCHKONTAKTIERUNGEN IN EINEM MEHRSCHICHTIGEN SUBSTRAT
PROCÉDÉ DE FORMATION DE TROUS D'INTERCONNEXION HAUTE DENSITÉ DANS UN SUBSTRAT MULTICOUCHES

(43) Date of publication of application: 02.12.2020
(73) Proprietor: Mitsubishi Electric R&D Centre Europe B.V., 1119 NS Schiphol Rijk Amsterdam (NL); Mitsubishi Electric Corporation, Tokyo 100-8310 (JP)
(72) Inventor: PERRIN, Rémi, 35708 RENNES Cedex 7 (FR); MORAND, Julien, 35708 RENNES Cedex 7 (FR); MRAD, Roberto, 35708 RENNES Cedex 7 (FR); MOLLOV, Stephan, 35708 RENNES Cedex 7 (FR)
(74) Representative: Plasseraud IP

(56) References cited:
- EP-A2- 2 048 921
- EP-A2- 2 911 484
- WO-A1-2010/012594
- WO-A1-2019/071283
- US-A1- 2005 112 798
- US-A1- 2015 319 842

## Description

### FIELD OF THE INVENTION

The invention relates to a method of forming high density vias in a multilayer substrate that electrically connects at least two conductive layers.

### TECHNICAL BACKGROUND

A classical multi-layer structure such as a Printed Circuit Board (PCB) structure comprises two or more electrically conductive layers such as copper positioned on opposite sides of an electrically insulating layer.

As is known in the art, plural Vertical Interconnect Accesses (VIA) are formed through the multiple layers. A via is a hole formed through a multilayer structure comprising, for instance, a top and bottom conductive layer positioned on opposite side of an insulating layer. The hole is then plated by a combination of electroless and electroplating processes with a conductive material such as a copper in order to form a conductive via. Thus, the bottom conductive layer is electrically connected to the top conductive layer through the vias. The current technique comprises successive steps of drilling, chemical copper deposition, electroplating deposition and surface finishing process.

In the applications of a package structure embedding at least one power device in a PCB, the electrical contact between the electrical contacts of the power device and the conductive layers are performed by conductive vias through electrically insulating layers. In such configuration, the connection made of copper vias and insulation material presents a high thermal resistance compared to the direct contact by soldering or silver sintering in traditional power modules. In order to obtain a higher thermal conductivity and a higher electrical performance from the power device to the substrates, high-density of vias connecting a power device to an adjacent conductive layer is required.

Current technique to form an array of holes in a multilayer structure in a PCB structure includes laser drilling technique and mechanical drilling technique. Mechanical drilling technique is used for applications with hole diameters of 100 µm or larger. Laser drilling technique is used to have the smallest via diameter with the maximum density of conductive vias in order to have the maximum heat transfer and the lowest electrical resistance.

The conventional laser drilling system comprises a laser for generating a laser beam, an optical system which focuses the laser beam at a desired location on the surface of a substrate for forming a via hole of a desired size and depth. The substrate is held in place by a holder. In order to form an array of holes, a galvo-scanning mirrors used to move the beam laser in X-axis and Y-axis directions for drilling the holes sequentially. Alternatively, the beam laser is maintained at a single desired location on the surface of the substrate and the holder may be mounted on a table which is movable in the X-axis and the Y-axis directions in a manner to form the via holes sequentially. There are a variety of different arrangements that could be utilized to move the focused beam laser relative to the substrate to be processed in order to direct the laser beam to a desired location on the surface of the substrate for drilling the holes. However, the position of the beam can only be ensured with a given accuracy and precision related to the mechanical means utilized for moving the table and/or the beam laser. It is difficult to accurately align a laser beam to produce multiples holes positioned in a desired lattice arrangement. Likewise, the holder cannot be moved with a level of accuracy suitable for manufacturing a high density array of vias. The size of the kerf is also limiting the minimum acceptable pitch between each holes.

Therefore, the number of copper vias is usually limited by manufacturing capabilities of laser. Typically, with the conventional laser drilling method, the density of vias is typical between 1 vias/mm² and 30 vias/mm².

Another solution is to perform a massive copper deposition on a cavity cut on top of the device electrode. However due to the dynamic of the electrodeposition, a range of form factor, in this case, the ratio between the hole diameter and the hole depth, is required to ensure a proper filling of the vias. Generally, the form factor of the cavity for massive copper deposition is not within the acceptable range.

A method for manufacturing at least one array of vias in a multilayer substrate is also known from following prior art documents WO-A-2019071283, EP-A-2048921, US-A-2015319842.

Thus there is a need for addressing this issue and/or other issues associated with the prior art.

### DESCRIPTION OF THE INVENTION

The invention aims at solving at least part of the problems listed above. In particular, the invention aims at providing a method for manufacturing a desired high-density array of vias in a multilayer substrate for power module application while keeping vias production depostion rate.

Another objet of the present invention is to provide a method which is relatively easy to perform in order to maintain the vias productions speeds in comparison to known method.

Another aim of the invention is to propose a power module with improved thermal transmission and power transmission due to the presence of high density vias.

Accordingly, a method for manufacturing at least one array of conductive vias in a multilayer substrate is disclosed, said substrate extending in a horizontal plane, said method comprising the steps of:
a) forming a first array of holes in the substrate,
b) filling the holes of the first array with an electrically conductive material in order to form a first array of conductive vias;
c) forming a second array of holes in the substrate, said second array being shifted from the first array along at least one direction in the horizontal plane in a manner that each hole of the second array is positioned between two adjacent and aligned holes of the first array and;
d) filling the holes of the second array with an electrically conductive material in order to form a second array of conductive vias ;
e) repeating the steps c) and d) until that the array of conductive vias has reached the desired density of electrically conductive material with a maximum up to an area fully covered with electrically conductive material.

In an embodiment, the method for manufacturing at least one array of conductive vias in a multilayer substrate comprises the steps of:
a) forming a first array of holes in the substrate,
b) filling the holes of the first array with an electrically conductive material in order to form a first array of conductive vias;
c) forming a second array of holes in the substrate, said second array being shifted from the first array along a first direction and along a second direction in the horizontal plane in a manner that each hole of the second array is positioned between two adjacent and aligned holes of the first array, the first direction being orthogonal to the second direction;
d) filling the holes of the second array with an electrically conductive material in order to form a second array of conductive vias;
e) forming a thirs array of holes in the substrate, said third array being shifted from the first array along the second direction in the horizontal plane in a manner that each hole of the third array is positioned between two adjacent and aligned holes of the first array;
f) filling the holes of the third array with an electrically conductive material in order to form a third array of conductive vias;
g) forming a fourth array of holes in the substrate, said fourth array being shifted from the first array along the third direction in the horizontal plane in a manner that each hole of the fourth array is positioned between two adjacent and aligned holes of the first array;
h) filling the holes of the fourth array with an electrically conductive material in order to form a fourth array of conductive vias.

In one embodiment, the substrate comprises:
- an electrically insulating core,
- at least one power device positioned within the electrically insulating core, said at least one power device having at least two electrical contacts,
- an electrically conductive layer positioned on each side of the electrically insulating core,
- said least one array of conductive vias being formed in the electrically insulating core and in the electrically conductive layers to connect at least one area of the electrical contact of the power device to the electrically conductive layer.

Preferably, the first and the second arrays have the same hole diameter and the same pitch.

Preferably, the electrically conductive material used during the filling step is copper.

Preferably, each hole has a diameter ranging between 1 µm and 5 mm and the spacing between two adjacent aligned holes of the first array has a length ranging between 1 µm and 1 mm.

In embodiments, the hole is made by a mechanic drilling method or by a laser drilling method.

According to another object of the invention, a power module is defined in claim 10.

### DESCRIPTION OF THE DRAWINGS

Other features and advantages of the invention will be apparent from the following detailed description given by way of non-limiting example, with reference to the accompanying drawings, in which:
- Figure 1 schematically illustrates the main steps of a method for manufacturing an array of conductive vias in a multilayer substrate according to an embodiment of the invention;
- Figure 2 schematically illustrates in detail an area of the array of conductive vias of figure 1;
- Figure 3 schematically illustrates a flowchart of a method for manufacturing an array of high density conductive vias according to an embodiment of the invention,
- Figure 4 represents an example of a power module comprising an array of high density conductive vias formed according to an embodiment of the invention.

### DETAILED DESCRIPTION OF AT LEAST ONE EMBODIMENT OF THE INVENTION

In this disclosure, the term "power module" refers to a package structure comprising at least one power device positioned within a multilayer structure like a PCB laminate in order to form a power module.

In this disclosure, the term "insulating layer" or "insulating core" refers to a layer or core made of thermally conductive and electrically insulating material such as a dielectric material.

In this disclosure, the term "conductive layer" refers to a layer made of electrically conductive material.

In this disclosure, the term "via" refers to a conducting path for electrically connecting a plurality of electrically conductive layers insulated by at least one electrically insulating layer in a multilayer substrate. A via is a through hole or non-through hole filled with an electrically conductive material such as copper.

The multilayer substrate may be a printed circuit board structure including multiples layers of electrically insulating material and electrically conductive material. Such multilayer structure may be utilized for manufacturing an electrical power module as will be explained in more details below.

For instance, the multilayer substrate may comprise at least one insulating layer, at least one top conductive layer positioned on a top surface of the insulating layer and at least one bottom conductive layer positioned on a bottom surface of the insulating layer.

As non-limiting examples, the electrically insulating layer may be made of of epoxy resin such as FR-4 glass epoxy, of polyimide, or in ceramic such as HTCC (High-Temperature Co-fired Ceramic) or LTCC (Low Temperature Co-fired Ceramic).

The material of the conductive layers is a metal such as copper, gold, stainless steel or nickel or an alloy of these metals. Especially, copper or copper alloy is preferred in consideration of processability, electrical characteristic etc.

The layers are electrically connected to one another through an array of vias arranged within the multilayer structure.

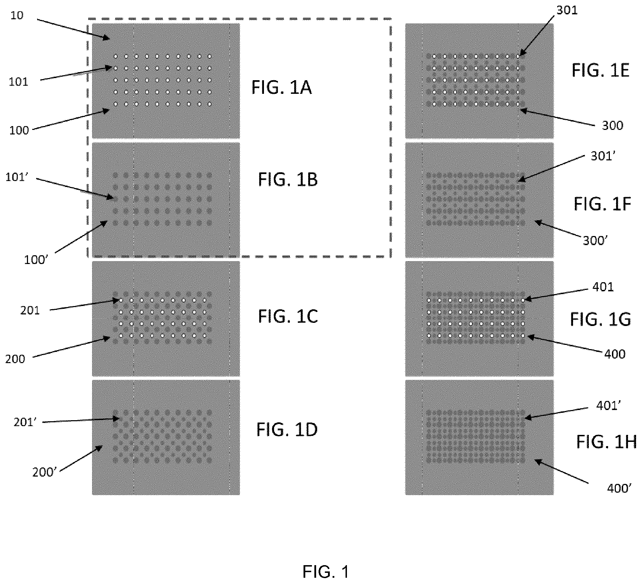

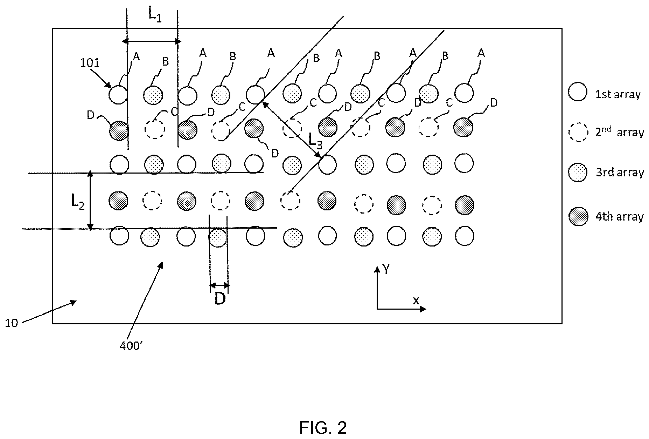

With reference to figures 1A to 1H and 2, a method for manufacturing an array of high density conductive vias in a multilayer substrate according to embodiments of the invention will now be described. The method allows maximizing the density of vias.

As shown in figure 2, the substrate 10 extends in a plane which defines a coordinate plane containing orthogonal axes X and Y. The multilayer substrate defines two opposite main surfaces which extend substantially along said plane (XY).

Referring now to figures 1A and 1B, the method of the present invention comprises a step of forming a first array of conductive vias 100'.

As shown in figure 1A, this step comprises a sub-step of forming a two dimensional array of holes 101 in the substrate 10. For instance, the array is a 2D array forming of 5 rows and 10 columns. The holes have been formed by laser drilling process through for instance the top conductive layer in a sequential manner. The process is similar for forming the holes through the bottom conductive layer.

The laser drilling system used for drilling an array of holes comprises a laser, an optical system which directs the beam laser at a desired location of the surface of the conductive layer of the substrate held on a table. The laser beam is produced by a CO2 laser or a UV laser. According to an example, the drilling system comprises a motion controller coupled to the table to move the substrate relative to the beam laser in both X-axis and Y-axis directions within the X-Y plane according to a predefined travel path allowing the system to drill sequentially an array of holes. The laser is actuated through a controller which receives the location information form the motion controller. The present invention is not limited to this example of laser drilling system. For instance, the drilling system may comprise a galvanometer which moves the beam laser focused on the surface of the substrate to drill sequentially the holes in order to form the array.

As shown in figure 2, the holes of this first array are designated by "A". The holes "A" are arranged to be spaced apart from each other by, a first distance in the X-axis direction, a second distance in the Y-axis direction and a third distance in both orthogonal directions. The first distance between the holes nearest from each other and aligned in the X-axis direction is indicated by L₁, the second distance between the holes nearest from each other and aligned in the Y-axis direction is indicated by L₂ and the third distance between the holes nearest from each other and aligned in both directions is indicated by L₃. In an embodiment, the distance L₁ is in a range between 5 µm and 500 µm and the L₂ is in a range between 5 µm and 500 µm. The diameter D of each hole is in a range between 1 µm and 400 µm.

It will be appreciated that although that figures 1 and 2 show round holes, other shapes of holes may be drilled.

It should be noted that although the 2D array is illustrated in a rectangular configuration, different 2D array may be provided, such as a square, circle, among other shapes.

As shown in figure 1B, the step comprises a second sub-step of plating the holes in order to form conductive vias 101'. During this plating process, the holes are filled with a conductive material. The plating process is not particularly limited. Any method known by those skilled in the art may be used as the method of plating. Thus, either electroplating or electroless plating or both can be used as the method of plating.

In order to overcome the inaccuracy of the laser drilling process and in order to increase the density of the vias, the method comprises additional steps wherein a plurality of second arrays of holes is formed. The second arrays are similar to the first array and shifted relative to the first array of holes in a manner that each holes of the second array is positioned between two adjacent and aligned holes of the first array.

As shown in figures 1C and 1D, an additional second step of forming a second array of conductive vias is performed.

The additional second step comprises a sub-step of forming a second array 200 of holes 201 in the substrate 10. The second array of holes is similar to the first array and is shifted relative to the first array in a manner that there is a displacement of the second array relative to the first array in both orthogonal directions. Thus each hole 201 of the second array is positioned between two adjacent and aligned holes of the first array in a diagonal direction, e.g. in both the X-axis and Y-axis direction.

Referring to figure 2, the holes 201 of the second array are designated by "C". According to the exemplary embodiment shown in figure 2, the second array is formed in a manner that there is near half pitch displacement of the second array relative to the first array in both orthogonal directions. In other words, each hole "C" of the second array is positioned at half pitch location relative to two holes of the first array in both the X-axis and Y-axis direction.

Referring now to figure 1D, the additional second step comprises a sub-step wherein the holes of the second array are filled with a conductive material to form an array 200' of vias 201'.

Thus, the substrate 10 comprises an array which is resulted from the two interleaved arrays of conducive 100', 200'. By doing a second array of vias, the density of vias has been increased.

As shown in figures 1E and 1F, an additional step of forming a third array of conductive vias is performed.

The additional second step comprises a sub-step of forming a third array 300 of holes 301 in the substrate 10. The third array 300 of holes is similar to the first array and is shifted relative to the first array in a manner that there is a displacement of the third array relative to the first array in only one of the orthogonal directions, e.g in the horizontal direction. Thus, each hole 301 of the third array is positioned between two adjacent and aligned holes of the first array in the X-axis direction.

Referring to figure 2, the holes of this third array displaced from the first array in the X-axis direction are designated by "B". According to the exemplary embodiment shown in figure 2, the third array is formed in a manner that there is near half pitch displacement of the third array relative to the first array in the X-axis direction. In other words, each hole "B" of the third array is positioned at half pitch location relative to two holes of the first array in the X-axis direction.

Referring to figure 1F, the additional step comprises a sub-step wherein the holes of the third array are filled with a conductive material to form an array 300' of vias 301'.

Thus, the substrate 10 comprises an array which is resulted from the three interleaved arrays 100', 200' and 300'.

As shown in figures 1G and 1H, an additional step of forming a fourth array of conductive vias is performed.

The additional second step comprises a sub-step of forming a fourth array of holes 401 in the substrate 10. The fourth array of holes is similar to the first array and is shifted relative to the first array in only one of the orthogonal directions, e.g in the vertical direction. Thus, each hole of the fourth array is positioned between two adjacent and aligned holes of the first array in the Y-axis direction.

Referring to figure 2, the holes of this fourth array shifted from the first array in the Y-axis direction are designated by "D". According to the exemplary embodiment shown in figure 2, the fourth array is formed in a manner that there is near half pitch displacement of the second array relative to the first array in the Y-axis direction. In other words, each hole "D" of the fourth array is positioned at half pitch location relative to two holes of the first array in the Y-axis direction.

Referring now to figure 1H, the additional step comprises a sub-step wherein the holes 401 of the fourth array 400 are filled with a conductive material to form an array 400' of vias 401'.

Thus, the substrate 10 comprises an array which is resulted from the four interleaved arrays 100', 200', 300' and 400'.

Although the figures 1 and 2 show an exemplary array comprising four interleaved arrays of holes, the present invention can be practiced with more than four arrays. Thus, the steps of forming the second arrays of vias can be repeated in a manner that the spacing between two holes of the first array is filled with the holes of the second arrays in the three directions. In other words, the method allows reaching the desired density of holes vias by performing multiples runs. Thus, a part of the desired density of conductive vias may be formed in a first run. The remaining of the conductive vias may be formed in multiples separate runs by interleaving different second arrays in order to obtain the desired density of holes vias, as previously described with respect to figures 1 and 2.

In an embodiment of the present invention, the steps of forming the second arrays of vias can be repeated until that each spacing between two adjacent and aligned holes of the first array along the three directions comprises nₘₐₓ hole(s) of the second array. The maximum number of steps for forming the second arrays is defined by the following relationship: nₘₐₓ=|L_{i=1,2,3}/(D/2)|, where L_{i=1,2,3} is the distance between two adjacent and aligned holes of the first array along the three directions and D is the diameter of the holes.
In another embodiment, the steps of forming the second arrays can be repeated in a manner to reach the desired density. Thus, the desired density of conductive vias may increase until a maximum corresponding to an area fully covered with electrically conductive material.

Thanks to the method, a plurality of arrays of vias can be made in separate steps in the same area of the substrate in a manner to maximize the density while overcoming the limitation of the laser drilling system. By doing a multi pass of laser drilling for forming at least four interleaved arrays of vias 100', 200', 300' and 400', high density vias can be improved at least by four times. As a result, the high density of vias provides a better thermal conductivity and a better power transfer trough the multilayer structure.

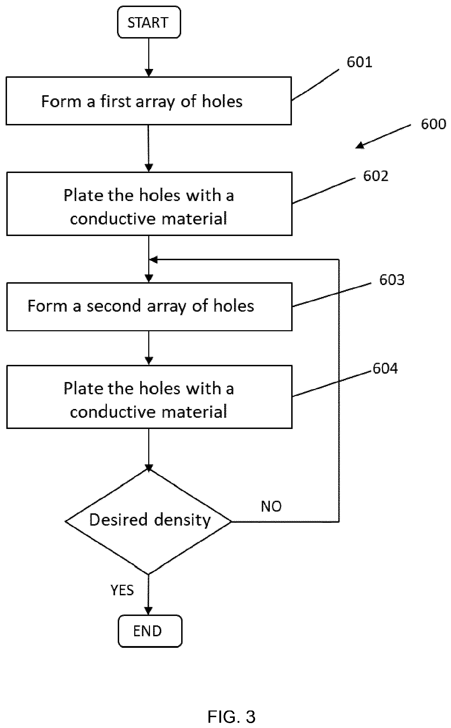

Figure 3 illustrates a flowchart of the method for forming high density vias in a substrate or in a PCB structure, in accordance with one embodiment.

At step 601, a first array of holes is formed. The substrate may be multiple layers of materials including dielectric material and conductive material.

At step, 602, the holes of the first array are plated with a conductive material.

At step 603, a second array of holes is formed in the substrate, said second array being similar to the first array. The diameter of the holes is similar as well as the pitch size. The second array is shifted from the first array along at least one direction in the horizontal plane in a manner that each hole of the second array is positioned between two adjacent and aligned holes of the first array. Thus, a second array of holes is formed along the three directions.

At step 604, the holes of the second array are plated with an electrically conductive material in order to form a second array of conductive vias.

According to an embodiment of the invention, the steps 603 and 604 are repeated until that each spacing between two adjacent and aligned holes of the first array along the three direction comprises nₘₐₓ holes of the second array, nₘₐₓ being defined by the relationship nₘₐₓ=|L_{i=1,2,3}/(D/2)|, where L_{i=1, 2, 3} is the distance between two adjacent and aligned holes of the first array along the three directions and D is the diameter of the holes.

According to another embodiment of the invention, the steps 603 and 604 are repeated until that the array of conductive vias has reached the desired density of electrically conductive material with a maximum up to an area fully covered with electrically conductive material.

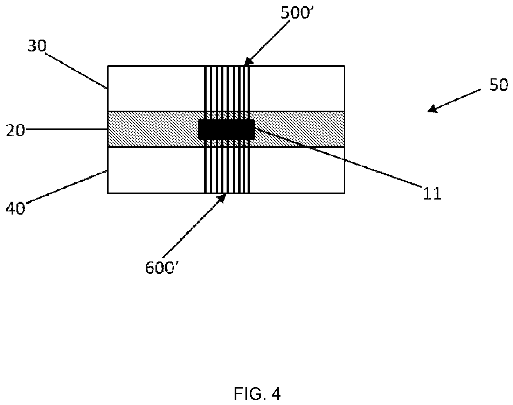

With reference to figure 4, the multilayer substrate 50 comprises an insulating layer 20, in which is embedded a power device 11 to form a power module, a top conductive layer 30 positioned on a top surface of the insulating layer and a bottom conductive layer 40 positioned on a bottom surface of the insulating layer.

The multilayer comprises an array of top high density conductive vias 500' and an array of bottom high density conductive vias 600' manufactured according the method of the present invention.

The power device 11 may be a diode or a transistor such as a MOSFET, JFET or IGBT. The power device has at least one electrical contact which may be arranged on opposite sides of the power device. The electrical contacts are metallic pads made of any suitable metal such as aluminum, gold, copper, silver, etc. For instance, the power device can be a diode having two opposite electrical contacts.

According to another example, the power device can be a transistor having three electrical contacts comprising a gate, a source, and a drain, or a gate, an emitter and a collector, according to the type of transistor.

The electrical power module may comprise at least one additional power device.

The electrical contact on a top surface of the power device is connected to the top conductive layers through at least one array of high density top conductive vias. In a similar manner, the electrical contact on a bottom surface of the power device is connected to the bottom conductive layers through at least one array of bottom conductive vias. This technique, called via stitching is used to tie together larger areas on different layers as well as a vertical electrical connection through different layers of the multilayer structure such as a PCB structure.

Thanks to the high density vias, the heat transfer from the power device to the external surface of the PCB structure is significantly improved. The electrical resistance is also reduced. This method is particularly interesting for improving the power density of a PCB structure in which is embedded at least a power device.

## Claims

1. A method for manufacturing at least one array of conductive vias (100', 200', 300', 400') in a multilayer substrate (10), said substrate extending in a horizontal plane, said method comprising the steps of:
a) forming a first array (100) of holes (101) in the substrate,
b) filling the holes of the first array with an electrically conductive material in order to form a first array of conductive vias (100');
c) forming a second array (200, 300, 400) of holes (201, 301, 401) in the substrate, said second array being shifted from the first array along at least one direction in the horizontal plane in a manner that each hole (201, 301, 401) of the second array is positioned between two adjacent and aligned holes (101) of the first array (100) and;
d) filling the holes of the second array with an electrically conductive material in order to form a second array of conductive vias (200', 300', 400');
e) repeating the steps c) and d) until that the array of conductive vias has reached the desired density of electrically conductive material with a maximum up to an area fully covered with electrically conductive material.

2. A method for manufacturing at least one array of conductive vias in a multilayer substrate (10) according to claim 1, said method comprising the steps of:
a) forming a first array (100) of holes (101) in the substrate,
b) filling the holes of the first array with an electrically conductive material in order to form a first array of conductive vias (100');
c) forming a second array (200) of holes (201) in the substrate, said second array being shifted from the first array along a first direction and along a second direction in the horizontal plane in a manner that each hole of the second array is positioned between two adjacent and aligned holes of the first array, the first direction being orthogonal to the second direction;
d) filling the holes of the second array with an electrically conductive material in order to form a second array of conductive vias (200');
e) forming a third array (300) of holes (301) in the substrate, said third array being shifted from the first array along the second direction in the horizontal plane in a manner that each hole of the third array is positioned between two adjacent and aligned holes of the first array;
f) filling the holes of the third array with an electrically conductive material in order to form a third array of conductive vias (300');
g) forming a fourth array (400) of holes (401) in the substrate, said fourth array being shifted from the first array along the third direction in the horizontal plane in a manner that each hole of the fourth array is positioned between two adjacent and aligned holes of the first array;
h) filling the holes of the fourth array with an electrically conductive material in order to form a fourth array of conductive vias (400').

3. A method for manufacturing at least one array of conductive vias according to claim 1 or 2, wherein the substrate comprises:
- an electrically insulating core (20),
- at least one power device (11) positioned within the electrically insulating core (20), said at least one power device (11) having at least two electrical contacts,
- an electrically conductive layer (30, 40) positioned on each side of the electrically insulating core (20),
- the at least one array of conductive vias being formed in the electrically insulating core and in the electrically conductive layers to connect at least one area of the electrical contact of the power device to the electrically conductive layer.

4. A method for manufacturing at least one array of conductive vias according to any one of claims 1 to 3, wherein the first and the second arrays (100, 200, 300, 400) have the same hole diameter and the same pitch.

5. A method for manufacturing at least one array of conductive vias according to any one of claims 1 to 4, wherein the electrically conductive material used during the filling step is copper.

6. A method for manufacturing at least one array of conductive vias according to any one of claims 1 to 5, wherein each hole has a diameter ranging between 1 µm and 5 mm.

7. A method for manufacturing at least one array of conductive vias according to any one of claims 1 to 6, wherein the spacing between two adjacent aligned holes of the first array has a length ranging between 1 µm and 1 mm.

8. A method for manufacturing at least one array of a conductive vias according to any one of claims 1 to 7, wherein the hole is made by a mechanic drilling method.

9. A method for manufacturing at least one array of conductive vias according to any one of claims 1 to 7, wherein the hole is made by a laser drilling method.

10. A power module (50) comprising:
- at least one electrically insulating core (20),
- at least one power device (11) positioned within the at least one electrically insulating core, said at least one power device having at least two electrical contact,
- an electrically conductive layer (30, 40) positioned on each side of the electrically insulating core,
- at least one array of conductive vias (500', 600') with a desired density of electrically conductive material manufactured by the method according to any one of claims 1 to 9, said desired density conductive vias extending from at least one electrical contact of the power device, through the electrically insulating core and the electrically conductive layer to connect at least one area of the electrical contact of the power device to the electrically conductive layer.

## Patentansprüche

1. Verfahren zur Herstellung wenigstens einer Anordnung leitfähiger Lücken (100', 200', 300', 400') in einem mehrschichtigen Substrat (10), wobei sich das Substrat in einer horizontalen Ebene erstreckt, wobei das Verfahren die folgenden Schritte umfasst:
a) Bilden einer ersten Anordnung (100) von Löchern (101) in dem Substrat;
b) Füllen der Löcher der ersten Anordnung mit einem elektrisch leitfähigen Material, um eine erste Anordnung leitfähiger Lücken (100') zu bilden;
c) Bilden einer zweiten Anordnung (200, 300, 400) von Löchern (201, 301, 401) in dem Substrat, wobei die zweite Anordnung von der ersten Anordnung entlang wenigstens einer Richtung in der horizontalen Ebene verschoben ist, in einer derartigen Weise, dass jedes Loch (201, 301, 401) der zweiten Anordnung zwischen zwei benachbarten und ausgerichteten Löchern (101) der ersten Anordnung (100) positioniert ist; und
d) Füllen der Löcher der zweiten Anordnung mit einem elektrisch leitfähigen Material, um eine zweite Anordnung leitfähiger Lücken (200', 300', 400') zu bilden;
e) Wiederholen der Schritte c) und d), bis die Anordnung leitfähiger Lücken die gewünschte Dichte an elektrisch leitfähigem Material erreicht hat, mit einem Maximum bis zu einem Bereich, welcher vollständig mit elektrisch leitfähigem Material bedeckt ist.

2. Verfahren zur Herstellung wenigstens einer Anordnung leitfähiger Lücken in einem mehrschichtigen Substrat (10) nach Anspruch 1, wobei das Verfahren die folgenden Schritte umfasst:
f) Bilden einer ersten Anordnung (100) von Löchern (101) in dem Substrat;
g) Füllen der Löcher der ersten Anordnung mit einem elektrisch leitfähigen Material, um eine erste Anordnung leitfähiger Lücken (100') zu bilden;
h) Bilden einer zweiten Anordnung (200) von Löchern (201) in dem Substrat, wobei die zweite Anordnung von der ersten Anordnung entlang einer ersten Richtung und entlang einer zweiten Richtung in der horizontalen Ebene verschoben ist, in einer derartigen Weise, dass jedes Loch der zweiten Anordnung zwischen zwei benachbarten und ausgerichteten Löchern der ersten Anordnung positioniert ist, wobei die erste Richtung orthogonal zu der zweiten Richtung ist;
i) Füllen der Löcher der zweiten Anordnung mit einem elektrisch leitfähigen Material, um eine zweite Anordnung leitfähiger Lücken (200') zu bilden;
j) Bilden einer dritten Anordnung (300) von Löchern (301) in dem Substrat, wobei die dritte Anordnung von der ersten Anordnung entlang der zweiten Richtung in der horizontalen Ebene verschoben ist, in einer derartigen Weise, dass jedes Loch der dritten Anordnung zwischen zwei benachbarten und ausgerichteten Löchern der ersten Anordnung positioniert ist;
k) Füllen der Löcher der dritten Anordnung mit einem elektrisch leitfähigen Material, um eine dritte Anordnung leitfähiger Lücken (300') zu bilden;
I) Bilden einer vierten Anordnung (400) von Löchern (401) in dem Substrat, wobei die vierte Anordnung von der ersten Anordnung entlang der dritten Richtung in der horizontalen Ebene verschoben ist, in einer derartigen Weise, dass jedes Loch der vierten Anordnung zwischen zwei benachbarten und ausgerichteten Löchern der ersten Anordnung positioniert ist; m)Füllen der Löcher der vierten Anordnung mit einem elektrisch leitfähigen Material, um eine vierte Anordnung leitfähiger Lücken (400') zu bilden.

3. Verfahren zur Herstellung wenigstens einer Anordnung leitfähiger Lücken nach Anspruch 1 oder 2, wobei das Substrat umfasst:
- einen elektrisch isolierenden Kern (20),
- wenigstens eine Leistungsvorrichtung (11), welche innerhalb des elektrisch isolierenden Kerns (20) positioniert ist, wobei die wenigstens eine Leistungsvorrichtung (11) wenigstens zwei elektrische Kontakte aufweist,
- eine elektrisch leitfähige Schicht (30, 40), welche an jeder Seite des elektrisch leitfähigen Kerns (20) positioniert ist,
- wobei die wenigstens eine Anordnung leitfähiger Lücken in dem elektrisch isolierenden Kern und in den elektrisch leitfähigen Schichten gebildet ist, um wenigstens einen Bereich des elektrischen Kontakts der Leistungsvorrichtung mit der elektrisch leitfähigen Schicht zu verbinden.

4. Verfahren zur Herstellung wenigstens einer Anordnung leitfähiger Lücken nach einem der Ansprüche 1 bis 3, wobei die erste und die zweite Anordnung (100, 200, 300, 400) den gleichen Lochdurchmesser und das gleiche Teilungsmaß aufweisen.

5. Verfahren zur Herstellung wenigstens einer Anordnung leitfähiger Lücken nach einem der Ansprüche 1 bis 4, wobei das elektrisch leitfähige Material, welches während des Füllschritts verwendet wird, Kupfer ist.

6. Verfahren zur Herstellung wenigstens einer Anordnung leitfähiger Lücken nach einem der Ansprüche 1 bis 5, wobei jedes Loch einen Durchmesser im Bereich zwischen 1 µm und 5 mm aufweist.

7. Verfahren zur Herstellung wenigstens einer Anordnung leitfähiger Lücken nach einem der Ansprüche 1 bis 6, wobei der Abstand zwischen zwei benachbarten ausgerichteten Löchern der ersten Anordnung eine Länge im Bereich zwischen 1 µm und 1 mm aufweist.

8. Verfahren zur Herstellung wenigstens einer Anordnung leitfähiger Lücken nach einem der Ansprüche 1 bis 7, wobei das Loch durch ein mechanisches Bohrverfahren hergestellt wird.

9. Verfahren zur Herstellung wenigstens einer Anordnung leitfähiger Lücken nach einem der Ansprüche 1 bis 7, wobei das Loch durch ein Laserbohrverfahren hergestellt wird.

10. Leistungsmodul (50), umfassend:
- wenigstens einen elektrisch isolierenden Kern (20),
- wenigstens eine Leistungsvorrichtung (11), welche innerhalb des wenigstens einen elektrisch isolierenden Kerns positioniert ist, wobei die wenigstens eine Leistungsvorrichtung wenigstens zwei elektrische Kontakte aufweist,
- eine elektrisch leitfähige Schicht (30, 40), welche an jeder Seite des elektrisch leitfähigen Kerns positioniert ist,
- wenigstens eine Anordnung leitfähiger Lücken (500', 600') mit einer gewünschten Dichte eines elektrisch leitfähigen Materials, welche durch das Verfahren nach einem der Ansprüche 1 bis 9 hergestellt wird, wobei sich die leitfähigen Lücken mit gewünschter Dichte von wenigstens einem elektrischen Kontakt der Leistungsvorrichtung durch den elektrisch isolierenden Kern und die elektrische leitfähige Schicht erstrecken, um wenigstens einen Bereich des elektrischen Kontakts der Leistungsvorrichtung mit der elektrisch leitfähigen Schicht zu verbinden.

## Revendications

1. Procédé de fabrication d'au moins un réseau de trous d'interconnexion conducteurs (100', 200', 300', 400') dans un substrat multicouche (10), ledit substrat s'étendant dans un plan horizontal, ledit procédé comprenant les étapes de :
a) formation d'un premier réseau (100) de trous (101) dans le substrat,
b) remplissage des trous du premier réseau avec un matériau électriquement conducteur afin de former un premier réseau de trous d'interconnexion conducteurs (100') ;
c) formation d'un deuxième réseau (200, 300, 400) de trous (201, 301, 401) dans le substrat, ledit deuxième réseau étant décalé du premier réseau le long d'au moins une direction dans le plan horizontal d'une manière telle que chaque trou (201, 301, 401) du deuxième réseau est positionné entre deux trous (101) adjacents et alignés du premier réseau (100) et ;
d) remplissage des trous du deuxième réseau avec un matériau électriquement conducteur afin de former un deuxième réseau de trous d'interconnexion conducteurs (200', 300', 400') ;
e) répétition des étapes c) et d) jusqu'à ce que le réseau de trous d'interconnexion conducteurs ait atteint la densité souhaitée de matériau électriquement conducteur avec un maximum allant jusqu'à une zone entièrement couverte de matériau électriquement conducteur.

2. Procédé de fabrication d'au moins un réseau de trous d'interconnexion conducteurs dans un substrat multicouche (10) selon la revendication 1, ledit procédé comprenant les étapes de :
a) formation d'un premier réseau (100) de trous (101) dans le substrat,
b) remplissage des trous du premier réseau avec un matériau électriquement conducteur afin de former un premier réseau de trous d'interconnexion conducteurs (100') ;
c) formation d'un deuxième réseau (200) de trous (201) dans le substrat, ledit deuxième réseau étant décalé du premier réseau le long d'une première direction et le long d'une deuxième direction dans le plan horizontal d'une manière telle que chaque trou du deuxième réseau est positionné entre deux trous adjacents et alignés du premier réseau, la première direction étant orthogonale à la deuxième direction ;
d) remplissage des trous du deuxième réseau avec un matériau électriquement conducteur afin de former un deuxième réseau de trous d'interconnexion conducteurs (200') ;
e) formation d'un troisième réseau (300) de trous (301) dans le substrat, ledit troisième réseau étant décalé du premier réseau le long de la deuxième direction dans le plan horizontal d'une manière telle que chaque trou du troisième réseau est positionné entre deux trous adjacents et alignés du premier réseau ;
f) remplissage des trous du troisième réseau avec un matériau électriquement conducteur afin de former un troisième réseau de trous d'interconnexion conducteurs (300') ;
g) formation d'un quatrième réseau (400) de trous (401) dans le substrat, ledit quatrième réseau étant décalé du premier réseau le long de la troisième direction dans le plan horizontal d'une manière telle que chaque trou du quatrième réseau est positionné entre deux trous adjacents et alignés du premier réseau ;
h) remplissage des trous du quatrième réseau avec un matériau électriquement conducteur afin de former un quatrième réseau de trous d'interconnexion conducteurs (400').

3. Procédé de fabrication d'au moins un réseau de trous d'interconnexion conducteurs selon la revendication 1 ou 2, dans lequel le substrat comprend :
- un noyau électriquement isolant (20),
- au moins un dispositif de puissance (11) positionné à l'intérieur du noyau électriquement isolant (20), ledit au moins un dispositif de puissance (11) ayant au moins deux contacts électriques,
- une couche électriquement conductrice (30, 40) positionnée sur chaque côté du noyau électriquement isolant (20),
- l'au moins un réseau de trous d'interconnexion conducteurs étant formé dans le noyau électriquement isolant et dans les couches électriquement conductrices pour connecter au moins une zone parmi le contact électrique du dispositif de puissance à la couche électriquement conductrice.

4. Procédé de fabrication d'au moins un réseau de trous d'interconnexion conducteurs selon l'une quelconque des revendications 1 à 3, dans lequel le premier et le deuxième réseau (100, 200, 300, 400) ont le même diamètre de trou et le même pas.

5. Procédé de fabrication d'au moins un réseau de trous d'interconnexion conducteurs selon l'une quelconque des revendications 1 à 4, dans lequel le matériau électriquement conducteur utilisé pendant l'étape de remplissage est du cuivre.

6. Procédé de fabrication d'au moins un réseau de trous d'interconnexion conducteurs selon l'une quelconque des revendications 1 à 5, dans lequel chaque trou a un diamètre se situant dans la plage entre 1 µm et 5 mm.

7. Procédé de fabrication d'au moins un réseau de trous d'interconnexion conducteurs selon l'une quelconque des revendications 1 à 6, dans lequel l'espacement entre deux trous alignés adjacents du premier réseau a une longueur se situant dans la plage entre 1 µm et 1 mm.

8. Procédé de fabrication d'au moins un réseau de trous d'interconnexion conducteurs selon l'une quelconque des revendications 1 à 7, dans lequel le trou est réalisé par un procédé de perçage mécanique.

9. Procédé de fabrication d'au moins un réseau de trous d'interconnexion conducteurs selon l'une quelconque des revendications 1 à 7, dans lequel le trou est réalisé par un procédé de perçage au laser.

10. Module de puissance (50) comprenant :
- au moins un noyau électriquement isolant (20),
- au moins un dispositif de puissance (11) positionné à l'intérieur de l'au moins un noyau électriquement isolant, ledit au moins un dispositif de puissance ayant au moins deux contacts électriques,
- une couche électriquement conductrice (30, 40) positionnée sur chaque côté du noyau électriquement isolant,
- au moins un réseau de trous d'interconnexion conducteurs (500', 600') avec une densité souhaitée de matériau électriquement conducteur fabriqué par le procédé selon l'une quelconque des revendications 1 à 9, lesdits trous d'interconnexion conducteurs à densité souhaitée s'étendant à partir d'au moins un contact électrique parmi le dispositif de puissance, à travers le noyau électriquement isolant et la couche électriquement conductrice pour connecter au moins une zone de contact électrique du dispositif de puissance à la couche électriquement conductrice.
